# EUROPÄISCHE PATENTSCHRIFT

(11) **EP 1 126 602 B1**
(45) Veröffentlichungstag und Bekanntmachung des Hinweises auf die Patenterteilung: **17.08.2011**
(21) Anmeldenummer: 01102577.2
(22) Anmeldetag: 06.02.2001
(51) Int. Cl.: H03H 9/17

(54) **Piezoresonator**
Piezoelectric resonator
Résonateur piézoélectrique

(30) Priorität: 18.02.2000 DE 10007577
(43) Veröffentlichungstag der Anmeldung: 22.08.2001
(73) Patentinhaber: Avago Technologies Wireless IP (Singapore) Pte. Ltd., Singapore 768923 (SG)
(72) Erfinder: Aigner, Robert, Dr., 81675 München (DE); Marksteiner, Stephan, Dr., 85579 Neubiberg (DE)
(74) Vertreter: Dilg, Haeusler, Schindelmann Patentanwaltsgesellschaft mbH

(56) Entgegenhaltungen:
- EP-A- 0 609 555
- EP-A- 0 949 756
- EP-A- 0 962 999
- US-A- 5 446 306
- US-A- 5 587 620

## Beschreibung

Die vorliegende Erfindung betrifft einen Dünnfilm-Piezoresonator, der insbesondere als Filter in BAW-Bauelementen eingesetzt werden kann.

In BAW-Bauelementen (Bulk acoustic wave) wird der piezoelektrische Effekt, der in bestimmten Materialien auftritt, ausgenutzt, um mittels angelegter elektrischer Spannungen in dem Material eine mechanische Spannung zu erzeugen. Umgekehrt erzeugen mechanische Verformungen in einem piezoelektrischen Material elektrische Spannungen. Schichten aus piezoelektrischem Material, im Folgenden als Piezoschichten bezeichnet, können zu akustischen Schwingungen im Bereich von GHz-Frequenzen angeregt werden, wenn sie eine geeignete Dicke im Bereich von einigen Mikrometern aufweisen und zwischen Elektrodenschichten angeordnet sind. Wird die Piezoschicht akustisch von der Umgebung isoliert, können stehende Wellen erzeugt werden, und das Bauelement kann in Resonanz betrieben werden. Eine Anwendung dieses Prinzips ist von Quarzuhren, Kristallfiltern und BAW-Filtern bekannt. Die akustische Isolation kann dadurch bewerkstelligt werden, dass die Piezoschicht als dünne Membran angebracht wird, so dass sie ringsum von Luft umgeben ist. Eine andere Möglichkeit besteht darin, akustische Bragg-Reflektoren als Stapel von Schichten der Dicke einer viertel Wellenlänge einzusetzen. Die einzelnen Schichten des Bragg-Reflektors sind dabei aus Materialien unterschiedlicher akustischer Impedanzen. Die Dicke der Piezoschicht bestimmt wesentlich die Resonanzfrequenz. Daher wirken sich Schichtdickenschwankungen beim Herstellungsprozess deutlich auf die Resonanzeigenschaften eines BAW-Bauelementes aus. In der EP 0 865 157 A2 ist ein BAW-Filter mit zwei als SCF (Stacked Crystal Filter) angeordneten piezoelektrischen Schichten ähnlicher Materialien und Dicke beschrieben.

Aus der EP 0 962 999 A2 ist eine Resonatoranordnung bekannt, welche ein Substrat aufweist, auf dem zumindest ein akustischer Volumenresonator angeordnet ist. Der akustische Volumenresonator kann von dem Substrat mittels einer akustischen Spiegelstruktur akustisch isoliert werden. Die Spiegelstruktur stellt einen Bragg-Reflektor mit mehreren Schichten dar. Die Schichten weisen jeweils eine Dicke auf, die einem Viertel der Wellenlänge von akustischen Schwingungen mit der Resonanzfrequenz des Volumenresonators entspricht. Die Schichten haben abwechselnd eine hohe und eine niedrige akustische Impedanz.

Bei einem Dünnfilm-Piezoresonator kann die Resonanzfrequenz nachgestimmt werden, indem eine strukturierte Schicht auf die Piezoschicht aufgebracht wird. Statt einer Strukturierung einer einzelnen Schicht kann eine Folge von mehreren unterschiedlich dicken und unstrukturierten Schichten aufgebracht werden, um eine oder mehrere Resonanzfrequenzen zu unterdrücken. Mit angeschlossenen Kapazitäten oder einer angelegten Gleichspannung kann die Resonanzfrequenz verschoben werden. Der Abstimmbereich ist dabei aber sehr gering und für praktische Zwecke kaum ausreichend. Auch bei sehr hohen anliegenden Gleichspannungen ist die relative Längendehnung typischer für Piezoschichten verwendeter Materialien (z.B. ZnO, AlN, PbZrTi) weniger als 0,1 %. Materialien mit effizienterer Längenausdehnung, wie z.B. das Polymer PVDF, sind in dem Bereich hoher Frequenzen ungeeignet.

Aus der US 5,446,306 ist ein Dünnfilm-Piezoresonator bekannt, dessen Resonanzfrequenz durch das Anlegen einer elektrischen Gleichspannung auf einen gewünschten Wert eingestellt werden kann. Der Dünnfilm-Piezoresonator weist eine erste piezoelektrische Schicht 18 auf, die zwischen einer ersten Elektrode 22 und einer dritten Elektrode 32 angeordnet ist. Der Dünnfilm-Piezoresonator weist ferner eine zweite piezoelektrische Schicht 18 auf, die zwischen der dritten Elektrode 32 und einer zweiten Elektrode 20 angeordnet ist (siehe Figur 4). Zum Einstellen der Resonanzfrequenz des Dünnfilm-Piezoresonators kann die elektrische Gleichspannung zwischen der ersten Elektrode 22 und der zweiten Elektrode 20 angelegt werden.

Aufgabe der vorliegenden Erfindung ist es, einen Piezoresonator anzugeben, der im Bereich von HF-Frequenzen über einen weiten Bereich abstimmbar ist.

Diese Aufgabe wird mit dem Piezoresonator mit den Merkmalen des Anspruches 1 gelöst. Ausgestaltungen ergeben sich aus den abhängigen Ansprüchen.

Der erfindungsgemäße Piezoresonator verwendet eine Schicht aus zumindest vorwiegend elektrostriktivem Material, um die Resonanzfrequenz eines piezoelektrischen BAW-Resonators abzustimmen. Unter einem elektrostriktiven Material ist ein Material zu verstehen, das die Umkehrung des piezoelektrischen Effekt, die Elektrostriktion zeigt. Die Elektrostriktion besteht darin, dass beim Anlegen einer elektrischen Spannung eine mechanische Deformation des elektrostriktiven Materiales auftritt. Der Effekt der Elektrostriktion wird z.B. bei einem Quarzkristall ausgenutzt, der durch Anlegen einer elektrischen Wechselspannung in resonante Schwingungen versetzt wird. Der piezoelektrische Effekt ermöglicht umgekehrt das Abgreifen einer elektrischen Spannung, falls das piezoelektrische Material geeignet deformiert wird. Es gibt rein elektrostriktive Materialien, bei denen dieser umgekehrte Effekt nicht oder in nur sehr geringem Ausmaß auftritt, die also bei einer Verformung keine elektrische Spannung erzeugen. Diese Eigenschaft besitzen einige nichtpolare Keramiken, insbesondere PMN (Bleimagnesiumniobat) und eine Reihe von Polymeren (z. B. Polyvinylidenfluoridhexafluoropropylen [P(VF2-HFP)]). Solche in diesem Sinn elektrostriktive Materialien werden bei dem erfindungsgemäßen Piezoresonator als elektroaktive Schicht eingesetzt. Der Effekt der Elektrostriktion ist in hohem Maße nichtlinear; die mechanische Verformung ist abhängig von dem Quadrat des vorhandenen elektrischen Feldes. Bei dem erfindungsgemäßen Piezoresonator wird die Piezoschicht mit einer elektrostriktiven Schicht, vorzugsweise aus einem rein elektrostriktiven Material, verbunden, die bei Anlegen einer Gleichspannung in der vertikalen Richtung kontrahiert, also gedünnt wird. Damit wird die Resonanzfrequenz des Schichtstapels geändert. Die Piezoschicht ist zwischen Elektrodenschichten angeordnet. Die elektrostriktive Schicht ist auf einer dieser Elektroden auf der von der Piezoschicht abgewandten Seite angeordnet und verfügt über eine dritte Elektrodenschicht zum Anlegen der Gleichspannung.

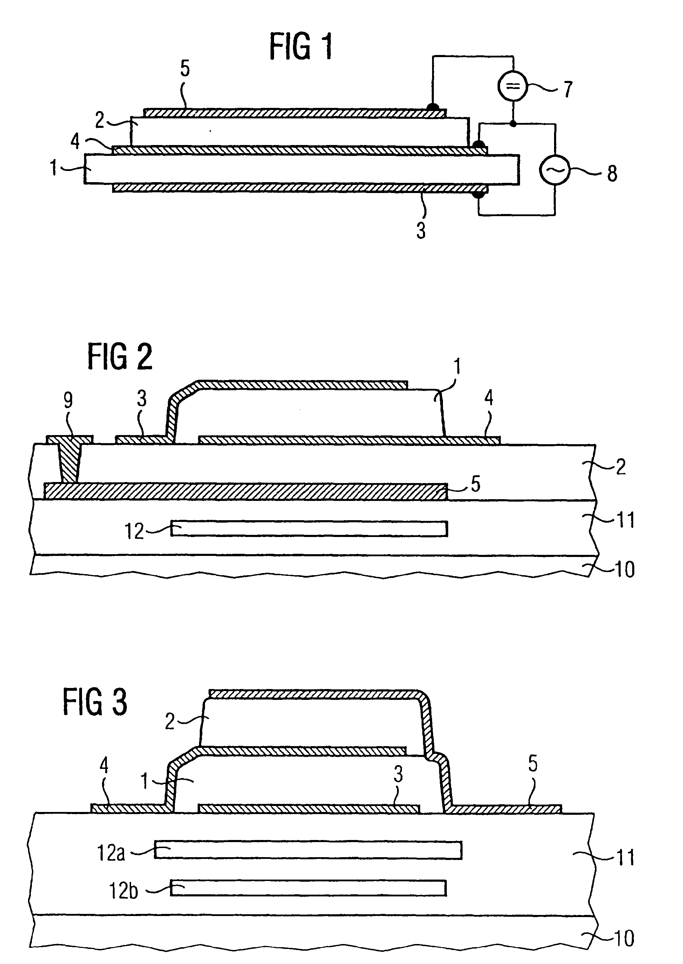

Es folgt eine genauere Beschreibung von Beispielen des erfindungsgemäßen Piezoresonators anhand der Figuren 1 bis 3. Die Figuren 1 bis 3 zeigen drei Ausführungsbeispiele des Piezoresonators im Querschnitt.

Die elektrostriktive Schicht wird im Folgenden auch als elektroaktive Schicht bezeichnet.

In Figur 1 ist im Querschnitt der prinzipielle Aufbau des erfindungsgemäßen Piezoresonators dargestellt. Die Piezoschicht 1 befindet sich zwischen einer ersten Elektrodenschicht 3 und einer zweiten Elektrodenschicht 4. An diese Elektrodenschichten ist eine Wechselspannung 8, das HF-Signal, angelegt. Auf der zweiten Elektrodenschicht 4 befindet sich die elektroaktive Schicht 2 mit einer dritten Elektrodenschicht 5. An die zweite Elektrodenschicht 4 und die dritte Elektrodenschicht 5 ist die Gleichspannung 7 angelegt, mit der die Abstimmung der Resonanzfrequenz erfolgt.

In Figur 2 ist ein Ausführungsbeispiel dargestellt, bei dem die Piezoschicht 1 über der elektroaktiven Schicht 2 angeordnet ist. Das Bauelement befindet sich auf einem Substrat 10 und ist dagegen durch einen Bragg-Reflektor akustisch isoliert. Dieser Bragg-Reflektor besteht aus einer Schichtfolge von Schichten aus Materialien, die abwechselnd eine niedrige und eine hohe akustische Impedanz aufweisen. In dem in Figur 2 im Querschnitt dargestellten Beispiel ist eine Schicht 12 aus Material hoher akustischer Impedanz in eine Schicht 11 aus einem Material niedriger akustischer Impedanz eingebettet. Die für das Anlegen der Gleichspannung vorgesehene dritte Elektrodenschicht 5 bildet eine weitere Schicht aus einem Material hoher akustischer Impedanz. Die elektroaktive Schicht 2 selbst wirkt wieder als Schicht niedriger akustischer Impedanz, so daß in diesem Beispiel die Piezoschicht 1 durch eine Schichtfolge aus drei Schichten niedriger akustischer Impedanz alternierend mit Schichten hoher akustischer Impedanz von dem Substrat 10 akustisch isoliert ist. Die dritte Elektrodenschicht 5 ist in diesem Beispiel zwischen der Schicht 11 aus einem Material niedriger akustischer Impedanz und der elektroaktiven Schicht 2 angeordnet. Um den elektrischen Anschluss der dritten Elektrodenschicht 5 zu ermöglichen, befindet sich darauf ein durch ein Kontaktloch angeschlossener elektrischer Kontakt 9.

Bei dem in Figur 3 dargestellten Ausführungsbeispiel ist ein Bragg-Reflektor vorhanden, der durch zwei Schichten 12a,12b aus einem Material hoher akustischer Impedanz, die im Abstand zueinander in einer Schicht 11 aus einem Material niedriger akustischer Impedanz eingebettet sind, gebildet ist. Darauf befindet sich die erste Elektrodenschicht 3 mit der darauf angeordneten Piezoschicht 1. Die elektroaktive Schicht 2 ist hier auf der von dem Substrat 10 abgewandten Seite der Piezoschicht 1 zwischen der zweiten Elektrodenschicht 4 und der dritten Elektrodenschicht 5 angeordnet.

Auch bei dem Ausführungsbeispiel gemäß Figur 2 kann eine elektroaktive Schicht auf der von dem Substrat 10 abgewandten Seite der Piezoschicht 1 zusätzlich zu der dort bereits eingezeichneten elektroaktiven Schicht 2 vorhanden sein. Zum Anlegen der Gleichspannung an diese weitere elektroaktive Schicht muß in diesem Fall eine vierte Elektrodenschicht vorhanden sein. Damit ist es dann möglich, die Änderung der Resonanzfrequenz mittels auf beiden Seiten der Piezoschicht 1 vorhandener elektroaktiver Schichten herbeizuführen. Das Abstimmen der Resonanzfrequenz wird dadurch ggf. verbessert; es ergeben sich auch zusätzliche Möglichkeiten, das Design der Schichtdicken zu optimieren.

Es ist besonders vorteilhaft, für die elektroaktive Schicht ein rein elektrostriktives Material, das nicht den piezoelektrischen Effekt aufweist, zu verwenden. Damit wird erreicht, dass eine Verformung der elektroaktiven Schicht keine Auswirkungen auf das an der Piezoschicht anliegende HF-Signal hat. Die Verluste, die das HF-Nutzsignal infolge in der elektroaktiven Schicht auftretender Verschiebungsströme erleidet, haben daher keine verfälschende Rückwirkung auf das HF-Signal.

Mit dem erfindungsgemäßen Piezoresonator läßt sich auf einfache Weise ein wirksam abstimmbares HF-Filter herstellen. Die Grundfrequenz für einen einfachen Resonator mit dünnen Elektrodenschichten wird durch die stehende Welle gegeben, deren Wellenlänge gleich der halben Schichtdicke der Piezoschicht ist. Zusätzliche Schichten oder dickere Elektrodenschichten erhöhen die für den Resonator wirksame Gesamtschichtdicke und vermindern die Resonanzfrequenz. Eine dünnere Piezoschicht mit dickeren Elektrodenschichten oder mit zusätzlichen Schichten kombiniert reduziert die Bandweite des Resonators. Durch die Einstellung der jeweiligen Schichtdicken können daher die Eigenschaften des Filters in weiten Grenzen eingestellt werden. Wegen der Möglichkeit, die Grundfrequenz abzustimmen, ist es dabei nicht erforderlich, in jedem Fall eine möglichst große Bandbreite zu erreichen. Die Anwendungsmöglichkeiten des erfindungsgemäßen Piezoresonators sind daher wesentlich umfangreicher als die herkömmlicher HF-Filter mit fester Resonanzfrequenz. Auch beim Einsatz in Bauelementen, die für feste Frequenz vorgesehen sind, kann der erfindungsgemäße Piezoresonator von Vorteil sein, da die Frequenz unabhängig von Fertigungstoleranzen oder Temperaturschwankungen sehr leicht auf einen Sollwert nachgestimmt werden kann. Es genügt dazu, wenn die vereinfachte Ausführungsform gemäß Figur 2 verwendet wird, bei der die elektroaktive Schicht und die dritte Elektrodenschicht 5 Teil des die akustische Isolierung gegenüber dem Substrat 10 bewirkenden Bragg-Reflektors bilden. Mit dieser einfachen Struktur kann aber bereits ein Abstimmbereich von näherungsweise 2 % erreicht werden, was zum Nachstimmen einer festen Frequenz durchaus ausreicht. Die Dicke der elektroaktiven Schicht 2 ist hier vorzugsweise etwa ein Viertel der Wellenlänge der Resonanz.

Des Weiteren ist es möglich, die Schichtdicke der elektroaktiven Schicht größer zu machen als ein Viertel der Wellenlänge und den Resonator in einer höheren Eigenschwingungsmode zu betreiben. Dadurch wird zwar die Bandbreite der Resonanz etwas vermindert, aber der durchstimmbare Bereich gewinnt deutlich an Bandbreite. Wenn ein HF-Signal ohne Gleichspannungsanteil an die elektroaktive Schicht angelegt wird, beginnt die Schichtstruktur bei der doppelten Resonanzfrequenz zu schwingen. Das liegt daran, dass die Längenausdehnung von dem Quadrat der Spannung abhängt. Diese Schwingungen koppeln über in die Piezoschicht und können an den an der Piezoschicht angebrachten Elektrodenschichten erfasst werden. Wegen der Resonanzeigenschaften der Schichtstruktur ist dieser Effekt besonders ausgeprägt bei bestimmten Frequenzen. Bei diesen Frequenzen lässt sich so mit der erfindungsgemäßen Schichtstruktur eine Frequenzverdopplung oder eine Impedanzanpassung erreichen.

Die Elektrodenschichten können Materialien sein, wie sie von Metallisierungen auf Halbleiterbaulementen im Prinzip bekannt sind, wie z. B. Aluminium, Wolfram, Platin oder Molybdän. Vor dem Aufbringen der übrigen Schichten werden ggf. Schichten auf die Elektrodenschichten aufgebracht, die das Aufbringen oder Aufwachsen der weiteren Schichten erleichtern. Ein Substrat 10 ist typisch aus Silizium, Glas oder Galliumarsenid. Materialien niedriger akustischer Impedanz sind z.B. SiO₂ oder Si₃N₄. Materialien hoher akustischer Impedanz sind z.B. Wolfram oder Molybdän. Für die Piezoschicht können AlN, ZnO, PZT-Keramik (PbZrTi) oder Abwandlungen davon verwendet werden. Die elektroaktive Schicht ist vorzugsweise PMN (Bleimagnesiumniobat), das z. B. aufgestäubt (sputter) oder aufgedampft (CVD, Chemical Vapor Deposition) oder mittels des sogenannten Sol-Gel-Prozesses hergestellt werden kann. Außerdem kann ein Polymer wie das genannte P(VF2-HFP) als elektroaktive Schicht verwendet werden.

## Patentansprüche

1. Dünnfilm-Piezoresonator mit einer Piezoschicht (1) zwischen einer ersten Elektrodenschicht (3) und einer zweiten Elektrodenschicht (4),
wobei eine dritte Elektrodenschicht (5), sowie eine elektrostriktive Schicht (2) zwischen der dritten Elektrodenschicht (5) und der zweiten Elektrodenschicht (4), vorhanden sind,
wobei
die elektrostriktive Schicht (2) ein elektrostriktives Material aufweist, welches bei Anlegen einer elektrischen Spannung eine mechanische Deformation zeigt, welche abhängig von dem Quadrat eines durch die elektrische Spannung verursachten elektrischen Feldes ist.

2. Piezoresonator nach Anspruch 1, bei dem
die Piezoschicht (1) und die elektrostriktive Schicht (2) auf einer Folge (11,12;12a,12b) von Schichten angeordnet sind, die abwechselnd aus einem Material niedriger akustischer Impedanz und aus einem Material hoher akustischer Impedanz bestehen.

3. Piezoresonator nach Anspruch 2, bei dem
die elektrostriktive Schicht (2) als weitere Schicht niedriger akustischer Impedanz vorgesehen ist und
die dritte Elektrodenschicht (5) als weitere Schicht hoher akustischer Impedanz vorgesehen ist.

4. Piezoresonator nach einem der Ansprüche 1 bis 3, bei dem die elektrostriktive Schicht (2) Bleimagnesiumniobat ist.

5. Piezoresonator nach einem der Ansprüche 1 bis 3, bei dem die elektrostriktive Schicht (2) ein Polymer ist.

6. Piezoresonator nach einem der Ansprüche 1 bis 5, bei dem die Piezoschicht (1) AlN, ZnO oder eine PZT-Keramik (PbZrTi) ist.

## Claims

1. Thin film piezoelectric resonator with a piezoelectric layer (1) between a first electrode layer (3) and a second electrode layer (4), wherein
a third electrode layer (5) as well as an electrostrictive layer (2) between the third electrode layer (5) and the second electrode layer (4) are existent, wherein the electrostrictive layer (2) comprises an electrostrictive material which upon an application of an electric voltage exhibits a mechanical deformation which depends on the square of an electric field being generated by the electric voltage.

2. Piezoelectric resonator as set forth in claim 1, wherein
the piezoelectric layer (1) and the electrostrictive layer (2) are arranged on a sequence (11, 12; 12a, 12b) of layers, which consist in an alternating manner of a material with a low acoustic impedance and a material with a high acoustic impedance.

3. Piezoelectric resonator as set forth in claim 2, wherein
the electrostrictive layer (2) is provided as a further layer with a low acoustic impedance and
the third electrode layer (5) is provided as a further layer with a high acoustic impedance.

4. Piezoelectric resonator as set forth in any of the claim 1 to 3, wherein the electrostrictive layer (2) is lead magnesium niobate.

5. Piezoelectric resonator as set forth in any of the claim 1 to 3, wherein the electrostrictive layer (2) is a polymer.

6. Piezoelectric resonator as set forth in any of the claim 1 to 5, wherein the piezoelectric layer (1) is AlN, ZnO or a PZT ceramic (PbZrTi).

## Revendications

1. Résonateur piézo-électrique à couches minces avec une couche piézo-électrique (1) entre une première couche (3) et une deuxième couche (4) d'électrode, dans lequel une troisième couche d'électrode (5) ainsi qu'une couche électrostrictive (2) sont disponibles entre la troisième couche (5) et la deuxième couche (4) d'électrode,
la couche électrostrictive (2) étant composée d'un matériau électrostrictif qui présente, lors de la mise en place d'une tension électrique, une déformation mécanique dépendante du carré d'un champs électrique généré par la tension électrique.

2. Résonateur piézo-électrique selon la revendication 1, dans lequel la couche piézo-électrique (1) et la couche électrostrictive (2) sont disposées sur une succession (11, 12, 12a, 12b) de couches composées de façon alternée d'un matériau d'impédance acoustique faible et d'un matériau d'impédance acoustique élevée.

3. Résonateur piézo-électrique selon la revendication 2, dans lequel la couche électrostrictive (2) est prévue comme une autre couche d'impédance acoustique faible et la troisième couche d'électrodes (5) est prévue comme une autre couche d'impédance acoustique élevée.

4. Résonateur piézo-électrique selon l'une des revendications 1 à 3, dans lequel la couche électrostrictive (2) est du niobate-magnésium de plomb.

5. Résonateur piézo-électrique selon l'une des revendications 1 à 3, dans lequel la couche électrostrictive (2) est un polymère.

6. Résonateur piézo-électrique selon l'une des revendications 1 à 5, dans lequel la couche piézo-électrique (1) AlN, est un ZnO ou une céramique PZT (PbZrTi).
